**Europäisches Patentamt**

**European Patent Office**

**Office européen des brevets**

(19)

(11) **EP 1 473 836 B1**

(12) **EUROPEAN PATENT SPECIFICATION**

(45) Date of publication and mention
of the grant of the patent:
**02.08.2006 Bulletin 2006/31**

(51) Int Cl.:
**H03M 1/10** (2006.01)

(21) Application number: **03398002.0**

(22) Date of filing: **20.03.2003**

(54) **Digital-domain self-calibration and built-in self-testing techniques for high-speed integrated A/D converters using white gaussian noise**

Techniken zur Selbstkalibrierung im Digitalbereich und für den eingebauten Selbsttest von integrierten Hochgeschwindigkeits-A/D-Wandlern mit Hilfe von weissen Gauss-Geräuschen

Techniques d'autocalibration au domaine numérique et d'auto-test intégré pour les convertisseurs A/N intégrés à grande vitesse utilisant du bruit gaussien blanc

(84) Designated Contracting States:
**AT BE BG CH CY CZ DE DK EE ES FI FR GB GR HU IE IT LI LU MC NL PT RO SE SI SK TR**

(43) Date of publication of application:
**03.11.2004 Bulletin 2004/45**

(73) Proprietor: **Acacia Semiconductor, Lda.**
**Edif. Uninova, Suite 28**
**Campus FCT, Quinta da Torre**
**2829-516 Caparica (PT)**

(72) Inventors:
 • **Paulino, Nuno Filipe Silva Verissimo**
  **2825-114 / Caparica (PT)**
 • **Ortigueira, Manuel Duarte**
  **2825-114 / Caparica (PT)**
 • **Unterweissacher, Martin**
  **8010 Graz (AT)**

 • **Evans, Guiomar Gaspar de Andrade Evans**
  **D. Fisica**
  **Edificio C8**
  **campoGrande**
  **1749-016 Lisboa (PT)**
 • **Goes, Joao Carlos da Palma**
  **1170-156 Lisboa (PT)**

(56) References cited:
 **US-B1- 6 229 467**

 • **GOES J ET AL: "Digital-domain self-calibration technique for video-rate pipeline A&sol;D converters using Gaussian white noise" ELECTRONICS LETTERS, IEE STEVENAGE, GB, vol. 38, no. 19, 12 September 2002 (2002-09-12), pages 1100-1101, XP006019051 ISSN: 0013-5194**

**Description**

The present invention relates generally to integrated circuits, and particularly to a self-calibration technique employed in the design of high-speed analog-to-digital converters (ADC). When embedded within the ADC integrated circuit, the present invention can additionally be utilized as a cost-effective built-in self-testing (BIST) solution.

*A) BACKGROUND OF THE INVENTION*

The overall linearity of high-speed[1] Analog-to-Digital (A/D) converters (ADCs) is limited by linearity errors bounded around the 8-10 bit level originated by component mismatches present in standard CMOS fabrication processes[2]. This linearity can be enhanced by way of component trimming or self-calibration techniques. Since trimming components is considered an expensive solution, self-calibration methods either in the analogue or in the digital domain are commonly considered for extending the resolution as well as the linearity of such ADCs above the 10-bit level.

[1]- In the present context, high-speed refers to conversion rates higher than Mega-Samples per second (MS/s).

[2]- In switched-capacitor implementations this matching accuracy is originated by relative mismatches of unit capacitances used in the capacitor-arrays but also due to the effects of the finite DC gains of the amplifiers.

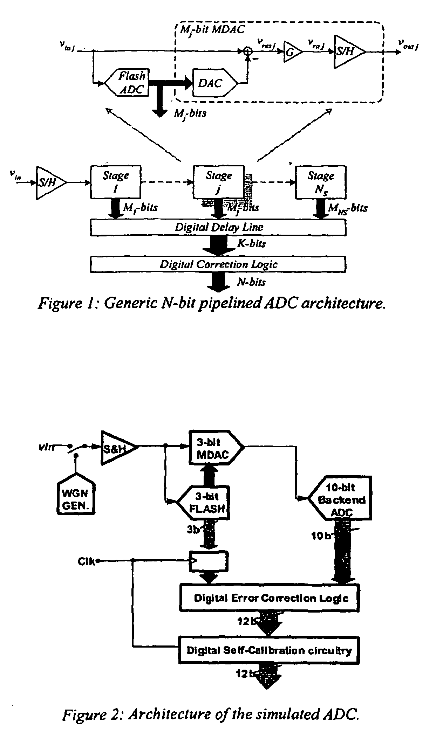

Beyond 10-bit resolution, high-speed ADCs are generally designed using pipeline architectures [1-6]. A generic *N*-bit high-speed pipelined ADC architecture consists of a front-end input sample-and-hold (S/H), followed by a cascade of $N_S$ pipelined stages as shown in Figure 1. Each stage employs a flash quantizer and a multiplying digital-to-analogue converter (MDAC) that also performs the sample-and-hold function. A generic stage *j* processes the input signal in two phases and it is responsible for the extraction of $M_j$ bits. In the sampling phase, the input voltage is sampled and the corresponding value is stored in the MDAC, while a $M_j$ quantization is performed by the flash quantizer. In the second phase, the residue voltage, $v_{resj}$, obtained by subtracting the digital-to-analog (D/A) reconstruction of the coarse quantization from the held input voltage, $v_{inj}$, is amplified by a factor of $G = 2^{M_j-1}$. This amplified residue, $v_{raj}$, is then held and applied to the next stage where identical operations are performed.

In an *N*-bit pipeline ADC comprising an $M_1$-bit front-end stage and $N_S$ stages, the overall linearity is mainly limited by the mismatches in the first (front-end) MDAC. A typical conversion characteristic consists basically of $2^{M_l}$ segments dislocated from an ideal straight-line. The gain-error of the MDAC affects the slope of these segments and is added to the jumps between two segments. A slightly lower than radix 2 inter-stage gain should be used in the first MDAC, because the gain-error resulting when the residue exceeds the allowed range can not be corrected by any digital technique [6]. This slightly reduces the full-scale range of the entire ADC, but ensures a successful self-calibration. The digital amounts of displacement can be measured during a calibration cycle and stored in a memory. Because fully differential MDACs exhibit code error symmetry, only one half of the calibrating-codes have to be calculated. These $2^{(M_1-1)}$ calibrating-codes can be later addressed and recalled during normal conversion mode, using the coarse digital outputs from the first stage *M1*-bit quantizer. The conversion characteristic is then moved back to the ideal line (minus the reduced gain) by digitally subtracting these codes.

Self-calibration techniques based on the measurement and digital storage of the errors for later correction have been reported [3-7]. These techniques can be classified into two main groups, depending on whether the calibration is performed in the analogue or in the digital domain. The proposed analogue techniques require separate calibration DACs and precision analogue components [3, 4]. On the other hand, digital calibration techniques do not require sophisticated analogue circuitry but put an extra burden on the digital part and require either additional stages or additional resolution in each calibrated stage to overcome the loss in effective resolution produced by digital truncation errors during calibration [5-7]. Furthermore, the MDAC of a calibrated stage has to be modified, by comprising a lot of additional switches, in order to perform the required code-error measurements [5, 7]. Moreover, the technique proposed in [6] can only be employed in 1.5-bit MDACs and, therefore, it is not suitable for power-optimized high-resolution architectures where multi-bit rather than single-bit front-end stages are usually preferred

A digital-domain self-calibration method according to the preamble of claim 1 is disclosed in "Electronics Letters, IEE, STEVENAGE, GB, vol. 38, no. 19, 12 September 2002, pages 1100-1101, XP006019051, GOES, J ET AL: "Digital-domain self calibration technique for video-rate pipeline A/D converters using Gaussian white noise".

*B) DESCRIPTION OF THE INVENTION*

The present invention is a design technique for self-calibrating the linearity of high-speed analog-to-digital converters (ADC). The present invention consists in applying a WGN analog stimulus at the ADC input and calculating the calibrating codes from the histogram of the output codes by way of a truncated on-chip read-only memory (ROM) table. As the WGN generator and the ROM table can be easily integrated in the A/D circuit by using the same substrate and technology, on-chip high-speed built-in self-testing (BIST) can additionally be performed with the present invention.

### B.1) Advantages of the Present Invention

This self-calibration design technique features several advantages when comparing with other methods [5-7]:

1. Design simplicity, power efficiency and real-time calibration capability.

2. As the self-calibration is external to the ADC circuitry, the design technique is readily suitable for any pipeline and multi-step A/D architectures with multi-bit front-end stages.

3. A wide-band WGN input stimulus can be generated on-chip by way of a high closed-loop gain amplifier with small input transistors and resistors employed as main noise sources. A detailed description of such circuits can be found in [8]. The input noise stimulus does not need to be necessarily white as long as it remains Gaussian.

4. The accuracy requirements of the standard deviation of the WGN generator are relaxed when compared with the desired linearity of the ADC.

5. Using a uniform spectral power density signal such as WGN enables a characterization of the ADC at full speed [9]

6. The use of an histogram for generating the calibrating codes will eliminate uncertainties due to noise.

7. When the calibrating circuitry is embedded in the ADC integrated circuit, this invention also enables high-speed BIST and therefore reduces the cost for testing the ADC.

### B.2) Description of the Self-calibration Technique

The description of the self-calibration technique is here illustrated for a generic pipeline ADC. However, the extension of this technique for other high-speed A/D architectures is straightforward as the present invention is external to the ADC.

By applying centered WGN to the input of the ADC, a ($2^{(M_1-1)}$ +1) bin histogram[3] can be computed by counting the number of occurrences of the output-codes inside these bins. Each bin covers a range of output codes that contain one expected step in the transfer characteristic. This histogram, $H[i]$, will have a Gaussian-shape, which will be distorted by the existing deviations of the segments.

[3] - Each bin in the histogram represents an interval of output digital codes of the ADC. The measured histogram represents, for all bins, the sum of the occurrences of the output codes comprised in each bin.

Assuming now that there is a specific memory (ROM) table, $T[i]$, with $2^{(M_1-1)}$ + 1 values, truncated and stored in a memory, and defined by

$$T[i] = (A[i])^{-1}, \quad A[i] = \int_{C_{bin}(i) - \frac{binwidth}{2}}^{C_{bin}(i) + \frac{binwidth}{2}} \left(\sigma \cdot \sqrt{2\pi}\right)^{-1} e^{\frac{-(x-\mu)^2}{2\sigma^2}} dx \; , \tag{1}$$

where $C_{bin}$ is the center of the bin and $A[i]$ represents the ideal histogram produced mathematically using a Gaussian distribution function with $\mu = 2^{(N-1)}$ and $\sigma = 2^{(N-1)}/2$. T[$i$] is used to normalize H[$i$], resulting in the ideal case in a uniformly distributed histogram with $2^n$ occurrences in each bin. The differences from this expected value can be used to calculate the calibrating-codes in 4 steps:

Step 1: Assuming a large number of samples $n$, the nonlinearity jump is given by

$$D[i] = \frac{(H[i] \cdot T[i] - 2^n) \cdot binwidth}{2^N} \cdot \frac{1}{2^{(n-N)}} \; . \tag{2}$$

The first term comprises the difference of the normalized occurrences to the ideal number reduced from 2" to the bin-size related value *(binwidth).* The second term scales this value using the expected number of samples in one bit. Hence *D[i]* contains the summed nonlinearity of one bin scaled to an equivalent INL step in one bit.

Step 2: Using *D[i]* it is then possible to calculate the segment deviations from the ideal transfer characteristic:

$$Dev[k] = D[k] + D[2^{M_1-1} - k] \quad \text{for} \quad 1 \le k < 2^{M_1-1}$$
$$Dev[k] = D[k] \quad \text{for} \quad k = 2^{M_1-1}$$
$$(3)$$

*D[i]*, excluding the central bin, is then added to the corresponding symmetric bin to eliminate small errors in symmetry caused by small offset voltages.

Step 3: The gain-error of the ADC, $\varepsilon_{GAIN}$, as well as the $2^{(M_1-1)}$ calibrating codes, $C_{CODE}(k)$, can be calculated according to

$$C_{CODE}(1) = -\varepsilon_{GAIN} = -0.5 \sum_{k=1}^{2^{(M_1-1)}} Dev[k]$$
$$C_{CODE}(k) = C_{CODE}(k-1) + 0.5 \cdot Dev[k], \quad 1 < k \le 2^{(M_1-1)}$$
$$(4)$$

Step 4: Due to the code error symmetry it is then possible to use the same calibrating-codes for the remaining segments:

$$C_{CODE}(k) = -C_{CODE}\left(2^{M_1} - k + 1\right), \quad k > 2^{(M_1-1)}$$
$$(5)$$

### B.3) Calculation of the Number of Required Samples

The number of samples in each bin is described by the binomial distribution, $B(\mu = n \cdot p[i], \sigma = \sqrt{n \cdot p[i] \cdot (n - p[i])})$, where *p[i]* represents the probability of a given sample falling into the *i*-th bin (that depends on the *binwidth* and on the σ of the WGN generator). An accuracy of 1/16 LSB@*N*-bit with a yield 3σ has to be reached to limit accumulated measurement errors below 1/2 LSB. To ensure this, the outermost bins representing the worst case are used to calculate the minimum number of samples. The number of samples needed to adjust the offset and the standard deviation of the WGN generator is calculated in the same way but using different bins and accuracy limits. The required accuracy concerning the statistical properties of the WGN stimulus depends mainly on the size of the bins. The standard deviation σ has a linear influence on the measured transition voltages [8] and on the non-linearities. Because the measurement errors due to an imperfectly adjusted σ accumulate over the observed code range, it is an advantage to use narrow bins at the code transitions of interest. To reach a DNL measurement error with less than the desired value $\xi_{BIN}$, $\Delta\sigma_{max}$ is defined by:

$$\Delta\sigma_{max} \approx \frac{\xi_{BIN} \cdot 2^N}{binwidth}$$
$$(6)$$

As shown in the simulation examples (see section *D*), a *binwidth* of 64 bits and a required $\xi_{BIN} \le 1/16 LSB$ allow the use of a 9-bit accurate σ to calibrate a 12-bit ADC. For a 14-bit ADC it would be required to use at least an 11-bit accurate σ. Therefore, the efficiency of this technique is mainly limited by the σ accuracy in the WGN generator. This accuracy can be easily adjusted during the generator setup using a digitally programmable gain amplifier (DPGA) together with a traditional successive-approximation algorithm. In addition, in order to obtain a symmetric histogram, the offset in the WGN and in the ADC should also be calibrated digitally during the generator setup. This is sufficient to ensure that the subsequent steps of the calibration of the ADC do not fail.

The wide-band WGN generator can be included on-chip by way of a high closed-loop gain amplifier with small input transistors and resistors employed as main noise sources. A detailed description of such circuits can be found in [8]. In fact, the input noise stimulus does not need to be necessarily white as long as it remains Gaussian.

### B.4) Modification of the Design Technique for BIST

Due to the ever-increasing circuit density present in a single chip and the growing need for embedding analog interfacing functions within large digital systems, built-in-self-test is becoming more and more important for reducing testing costs. In case of ADC circuits, it would be highly desirable to efficiently perform on-chip monotonicity and histogram tests for detecting circuits that would fail a given linearity specification.

By integrating the WGN circuit and the calibrating logic unit in the ADC, it is possible to perform on-chip built-in self-testing (BIST) for the ADC linearity. This is accomplished by setting *binwidth* = 1 in the ROM table and applying Step 1 and Step 2 of the calibrating algorithm. The required number of samples used in the histograms is again defined by (6).

### B.5) System-Level Simulation

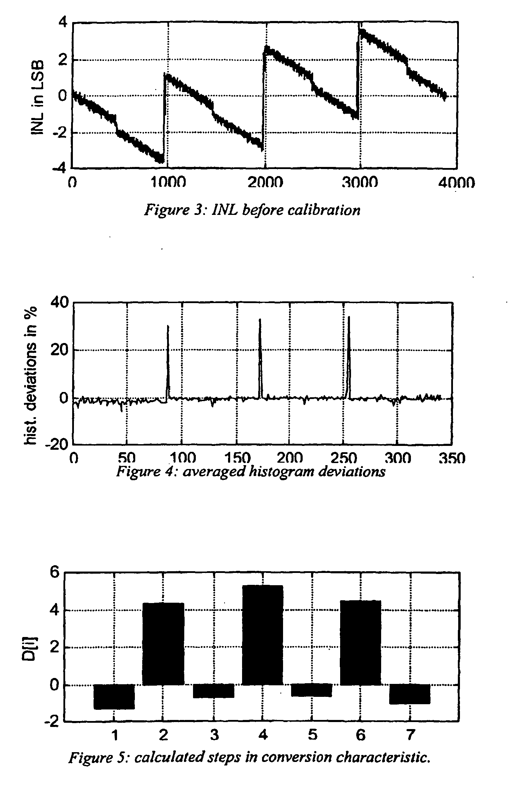

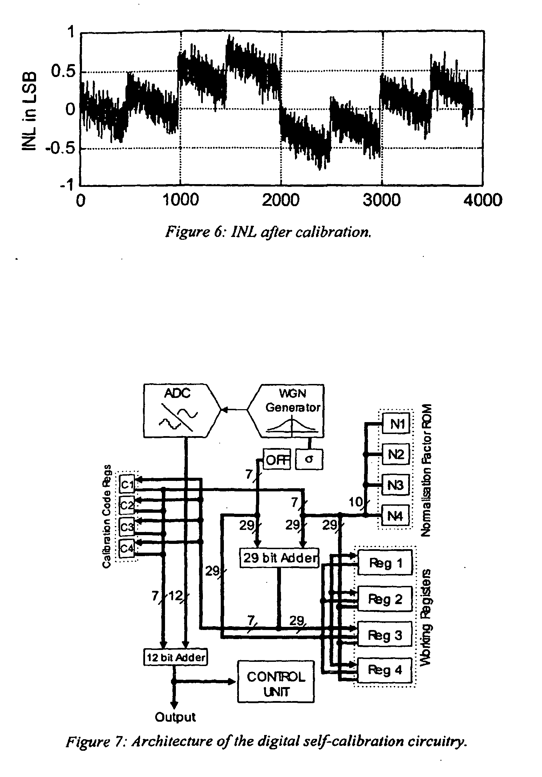

A 12-bit pipeline ADC employing the architecture presented in Figure 2 has been modeled at a functional level. This pipeline ADC consists in an input front-end sample-and-hold (S&H), in a 3-bit front-end stage comprising a 3-bit MDAC and a 3-bit flash quantizer and in a 10-bit ideal multi-stage pipeline backend ADC. Standard digital correction logic was included and the algorithm was implemented in the digital self-calibration circuitry block. The main static non-ideal effects were included, namely the offset voltages in the comparators of the flash quantizers and the limited matching accuracy (9-bit) in the capacitor-arrays in all MDAC blocks. The gain of the 3-bit front-end MDAC was nominally set to 3.9. The input-referred thermal noise of the ADC was also included and defined at 0.5 LSB below the quantization noise. An amount of $n = 2^{24}$ samples was used to compute the histogram $H[i]$ with 7 bins. This number of samples is sufficient for adjusting the WGN-generator and performing the self-calibration. The standard deviation of the WGN was set to $\pm 2\sigma$ at full-scale plus the maximal allowed error. Figures 3 and 6 show, respectively, the INL of the ADC before and after calibration, measured using a static method by sweeping the input of the ADC with a full-scale ramp with steps of 1/8 LSB at 12-bit. After calibration, the initial INL of +4.5/-4.0 LSB is improved within the range of $\pm$ 1LSB. Figure 4 shows the averaged histogram distortions *(binwidth = 10)* caused by the ADC and Figure 5 shows the steps in the conversion characteristic calculated by the self-calibrating algorithm *(binwidth = 64)*. Several simulations were carried-out with variations of the WGN generator offsets between $\pm$ 8 mV. The resulting maximum INL errors after calibration were always within $\pm$ 1 LSB, since about 1-bit is lost due to the accumulation of the digital truncation errors. The expected time for a complete calibration-cycle is about 600ms if the ADC is sampled at $F_s$ = 40 MS/s.

### B.6) Implementation of the Calibrating Logic Unit

The circuit depicted in Figure 7 is used to efficiently implement the digital self-calibration algorithm for the case of a 12 bit pipeline ADC. This circuit can be modified to implement the algorithm either for a different architecture of ADC or for a different ADC resolution. The 12-bit adder performs the correction using the calibrating-codes that are saved in 4 registers (C1 to C4). To reduce the number of required code-registers, the most significant bit of the ADC output decides if the codes are added or subtracted. Calibrating-codes with seven bit lengths allow for the correction of non-linearities up to 128 LSB, including the corrections enforced by the reduced inter-stage gain. The offset register (OFF) and the gain adjustment register (σ) are set during the initial calibration of the WGN generator using a similar method. The offset is then subtracted from the calibrating codes before the next histogram is taken, to ensure a symmetric behavior of the system after the WGN generator setup. During the initial sampling phase, the working registers (Reg 1 to Reg 4) contain the normalized values of the histogram bins. All the subsequent calculations such as subtractions and scaling can be done within these registers. As soon as the calculations described in section (A) (expressions 2 to 4) are accomplished, the working registers contain the new calibrating-codes and the calibrating-code registers are updated. Normalization factors stored in a ROM (N1 to N4) are employed, which are accumulated in the working registers every time a sample falls into the corresponding bin. This avoids the multiplication needed to normalize the histogram (2). All divisions to scale the calibrating-codes are radix 2 divisions, so they can be performed as a shift operation when the codes are written into the code registers. The 7 bit lines of the code registers are connected to the bus at the right position, so no additional shift unit is needed. The advantage of this system resides in its ability to perform multi-step calibration because already existing codes are used for new histograms but are not affected until they are updated.

### C) REFERENCES

[1] Frank Goodenough, "High-Resolution, High-Speed ADCs - High-Performance ADCs are Pipelining", *Electronic Design,* pp. 91-101, 1995.

[2] Bang-Sup Song, Michael F. Tompsett, Kadaba R. Lakshmikumar, "A 12-bit 1 Msample/s Capacitor Error-Averaging Pipelined A/D Converter", *IEEE Journal of Solid-State Circuits,* Vol. 23, No. 6, pp. 1324-1333, December 1988.

[3] Yuh-Min Lin, Beomsup Kim, Paul R. Gray, "A 13-b 2.5-MHz Self-Calibrated Pipelined A/D Converter in 3-μm CMOS", *IEEE Journal of Solid-State Circuits,* Vol. 26, No. 4, pp. 628-636, April 1991.

[4] J. Goes, J. C. Vital, Luis Alves, Nuno Ferreira, Pedro Ventura, Elmar Bach, J. Franca and Rudolf Koch, "A Low-power 14-b 5MS/s CMOS Pipelined ADC with Background Analog Self-Calibration", *IEEE 26rd European Solid-State Circuits Conference,* pp. 364-367, Sweden, September 2000.

[5] Sung-Ung Kwak, Bang-Sup Song and Kantilal Bacrania, " A 15b 5Msample/s Low-Spurious CMOS ADC ", *Proc. 1997 IEEE International Solid-State Circuits Conference,* pp. 146-147, February 1997.

[6] A. N. Karanicolas, H.-S. Lee, K. L. Bacrania, "A 15-b 1-Msample/s Digitally Self-Calibrated Pipeline ADC", *IEEE Journal of Solid-State Circuits,* Vol. 28, No. 12, pp. 1207-1215, Dec. 1993.

[7] S.-H. Lee, B.-S. Song, "Digital-Domain Calibration of Multistep Analog-to-Digital Converters", *IEEE Journal of Solid-State Circuits,* Vol. 27, No. 12, pp. 1679-1688, Dec. 1992.

[8] W. T. Holman, J. A. Connelly and A. B. Dowlatabadi, "An Integrated Analog/Digital Random Noise Source ", *IEEE Transactions on Circuits and Systems - I,* vol. 44, no. 6, June 1997.

[9] R. C. Martins and A. M. da Cruz Serra, "Automated ADC Characterization Using the Histogram Test Stimulated by Gaussian Noise", *IEEE Transactions on Instrumentation and Measurement,* Vol. 48, No. 2, pp. 471-474, April 1999.

**Claims**

1. A digital-domain self-calibration method for high-speed integrated analog-to-digital converters (ADC) based on a white Gaussian noise (WGN) input stimulus, said methods consisting of:

   a) applying a WGN stimulus to the input of the ADC;
   b) generating a digital histogram at the output;
   c) computing the calibrating codes from this digital histogram by using a memory table (ROM) containing the ideal histogram and a digital-domain 4-step algorithm;

   **characterized in that:**

   i) the ROM table, $T[i]$, uses $2^{(M_1-1)} + 1$ values defined by:

$$T[i] = (A[i])^{-1}, \quad A[i] = \int_{C_{tot}(i) - \frac{binwidth}{2}}^{C_{tot}(i) + \frac{binwidth}{2}} \left(\sigma \cdot \sqrt{2\pi}\right)^{-1} e^{\frac{-(x-\mu)^2}{2\sigma^2}} dx$$

   ii) the nonlinearity jump ($D[i]$) is computed by:

$$D[i] = \frac{(H[i] \cdot T[i] - 2^n) \cdot binwidth}{2^N} \cdot \frac{1}{2^{(n-N)}}$$

   iii) and the segment deviations from the ideal transfer characteristic ($Dev[k]$) are calculated by:

$$Dev[k] = D[k] + D[2^{M_1-1} - k] \quad \text{for} \quad 1 \le k < 2^{M_1-1}$$

$$Dev[k] = D[k] \quad \text{for} \quad k = 2^{M_1-1}$$

2. Self-calibration method according to claim 1, wherein the required number of samples used in the histograms is defined by:

$$\Delta\sigma_{max} = \frac{\xi_{BIN} \cdot 2^N}{binwidth}$$

3. Self-calibration method according to claim 1, wherein the calibration is performed at the maximum sampling rate of the ADC.

4. Analog-to-digital converter architecture for carrying out the self-calibration method according to claim 1, comprising:

   a) a WGN generating circuit;
   b) a ROM table (N1 to N4);
   c) two sets of registers (C1 to C4 and Reg 1 to Reg. 4);
   d) two adders and two additional registers, respectively, for storing the offset (OFF) and adjusting the standard deviation (σ) of the WGN generator.

5. ADC architecture according to claim 4, wherein the ROM table uses *binwidth* = 1 and is integrated together with the WGN generating circuit and with the ADC for performing on-chip built-in self-testing (BIST) for the ADC linearity measurements

**Patentansprüche**

1. Eine digitale Selbstkalibrierungsmethode für schnelle integrierte Analog-Digitalumsetzer (ADU) basierend auf gaussverteiltem weißen Rauschen (WGN) als Eingangsstimulus. Die hier beschriebene Methode besteht aus:

   a) Anlegen eines WGN Stimulus an den Eingang des ADU;
   b) Erzeugung eines digitalen Histogramms am Ausgang;
   c) Berechnung der Kalibrierungscodes von diesem digitalen Histogramm durch Anwendung einer im Speicher liegenden Tabelle (ROM), die das ideale Histogramm enthält, und durch einen 4-Schritt Algorithmus,

**dadurch gekennzeichnet**,

   i) daß die ROM Tabelle, $T[i]$, $2^{(M_1-1)} + 1$ Werte verwendet, definiert durch:

$$T[i] = (A[i])^{-1}, \quad A[i] = \int_{C_{bin}(i) - \frac{binwidth}{2}}^{C_{bin}(i) + \frac{binwidth}{2}} \left(\sigma \cdot \sqrt{2\pi}\right)^{-1} e^{\frac{-(x-\mu)^2}{2\sigma^2}} \, dx$$

   ii) daß die Sprünge durch Nichtlinearitäten *(D[i])* berechnet werden mit:

$$D[i] = \frac{(H[i] \cdot T[i] - 2^n) \cdot binwidth}{2^N} \cdot \frac{1}{2^{(n-N)}}$$

   iii) daß die Abweichungen der Segmente von der idealen Umsetzercharakteristik (*Dev[k]*) berechnet werden durch:

$$Dev[k] = D[k] + D[2^{M_1-1} - k] \quad \text{für} \quad 1 \le k < 2^{M_1-1}$$

$$Dev[k] = D[k] \quad \text{für} \quad k = 2^{M_1-1}$$

2. Selbstkalibrierungsmethode nach Anspruch 1, **dadurch gekennzeichnet, daß** die benötigte Anzahl an Stichproben für das Histogramm folgendermaßen bestimmt wird:

$$\Delta\sigma_{max} = \frac{\xi_{BIN} \cdot 2^N}{binwidth}$$

3. Selbstkalibrierungsmethode nach Anspruch 1, **dadurch gekennzeichnet, daß** die Kalibrierung bei maximaler Umsetzer-Rate erfolgt.

4. Analog-Digitalumsetzer Architektur um die Selbstkalibrierungsmethode nach Anspruch 1 auszuführen, bestehend aus:

   a) einer WGN generierenden Schaltung;
   b) einer ROM Tabelle (N1 bis N4);
   c) 2 Registerbänken (C1 bis C4 und Reg 1 bis Reg. 4);
   d) 2 Addierern und 2 zusätzliche Registern, jeweils eines zum Speichern des Offsets (OFF) und zur Einstellung der Standardabweichung ($\sigma$) des WGN Generators.

5. ADU Architektur nach Anspruch 4, **dadurch gekennzeichnet, daß** die ROM Tabelle eine *"binwidth"* = 1 verwendet und die zusammen mit der WGN generierenden Schaltung und dem ADU am Chip integriert wird, um einen Selbsttest (built-in self-test BIST) für ADU Nichtlinearitäten durchzuführen.

## Revendications

1. Une méthode d'autocalibration au domaine numérique pour les convertisseurs analogiques-numériques (A/N) intégrés à grande vitesse, qui est basée sur l'application d'un stimulus constitué para un signal de bruit gaussien blanc *(white gaussian noise* - WGN) et qui consiste en:

   a) l'application d'un stimulus WGN à l'entrée du convertisseur A/N;
   b) la génération d'un histogramme numérique à partir des codes obtenus à la sortie du convertisseur A/N;
   c) calcul des codes de calibration à partir de cet histogramme numérique, utilisant une table mémoire (*read only memory* - ROM) qui contient l'histogramme idéal et exécutant un algorithme au domaine numérique à 4 étapes;

   **caractérisée en ce que**:

   i) la table ROM, $T[i]$, utilise $2^{(M_1-1)} + 1$ valeurs définies par:

$$T[i] = (A[i])^{-1}, \quad A[i] = \int_{C_{bin}(i)-\frac{binwidth}{2}}^{C_{bin}(i)+\frac{binwidth}{2}} \left(\sigma \cdot \sqrt{2\pi}\right)^{-1} e^{\frac{-(x-\mu)^2}{2\sigma^2}} dx$$

   ii) le saut de non linéarité ($D[i]$) est calculé par:

$$D[i] = \frac{(H[i] \cdot T[i] - 2^n) \cdot binwidth}{2^N} \cdot \frac{1}{2^{(n-N)}}$$

iii) et les déviations des segments à partir de la caractéristique de transfert idéale *(Dev[k])* sont calculés par:

$$Dev[k] = D[k] + D[2^{M_1-1} - k] \quad \text{for} \quad 1 \le k < 2^{M_1-1}$$

$$Dev[k] = D[k] \quad \text{for} \quad k = 2^{M_1-1}$$

**2.** Une méthode d'autocalibration d'après la revendication 1, où le nombre d'échantillons utilisés dans les histogrammes est défini par:

$$\Delta\sigma_{max} = \frac{\xi_{BIN} \cdot 2^N}{binwidth}$$

**3.** Une méthode d'autocalibration d'après la revendication 1, où la calibration est réalisée à la fréquence maximale d'échantillonnage du convertisseur A/N.

**4.** Une architecture de conversion A/N à fin de réaliser la méthode d'autocalibration d'après la revendication 1, et qui comporte:

        a) un circuit générateur du signal de bruit gaussien blanc (WGN);
        b) une table de mémoire ROM (N1 à N4);
        c) deux groupes de registres (C1 à C4 et Reg 1 à Reg 4);
        d) deux additionneurs et deux registres supplémentaires, respectivement, pour garder le offset (OFF) et ajuster la déviation standard (σ) du générateur de bruit gaussien blanc (WGN).

**5.** Une architecture de conversion A/N d'après la revendication 4, où la table de mémoire ROM utilise *binwidth* = 1 et est intégrée avec le générateur de bruit gaussien blanc (WGN) et avec le convertisseur A/N, afin de réaliser un auto-test des mesures de linéarité du convertisseur A/N incorporé dans le propre circuit intégré *(built-in self-test -* BIST).

Figure 1: Generic N-bit pipelined ADC architecture.

Figure 2: Architecture of the simulated ADC.

*Figure 3: INL before calibration*

*Figure 4: averaged histogram deviations*

*Figure 5: calculated steps in conversion characteristic.*

*Figure 6: INL after calibration.*

*Figure 7: Architecture of the digital self-calibration circuitry.*